# EUROPÄISCHE PATENTSCHRIFT

(11) **EP 2 355 117 B1**
(45) Veröffentlichungstag und Bekanntmachung des Hinweises auf die Patenterteilung: **01.02.2012**
(21) Anmeldenummer: 10001358.0
(22) Anmeldetag: 10.02.2010
(51) Int. Cl.: H01H 13/06, H01H 13/86, H03K 17/96

(54) **Bedienvorrichtung für ein Haushaltsgerät**
Operating device for a domestic appliance
Dispositif de commande d'un appareil ménager

(43) Veröffentlichungstag der Anmeldung: 10.08.2011
(73) Patentinhaber: Miele & Cie. KG, 33332 Gütersloh (DE)
(72) Erfinder: Banmann, Johann, 3334 Gütersloh (DE); Bleidorn, Frank, 33335 Gütersloh (DE); Boo, Philipp, 33607 Bielefeld (DE); Büse, Oliver, 59597 Erwitte (DE); Evertzberg, Frank, 33428 Marienfeld (DE); Hunger, Helmut, 33335 Gütersloh (DE); Radusin, Darko, 33619 Bielefeld (DE); Ter Vehn, Hans-Jürgen, 26723 Emden (DE)

(56) Entgegenhaltungen:
- WO-A1-2009/003716
- DE-U1- 20 113 221
- DE-U1- 29 721 212
- US-A1- 2002 144 886
- US-A1- 2007 285 872

## Beschreibung

Die Erfindung betrifft eine Bedienvorrichtung für ein Haushaltgerät, umfassend ein Blendenteil mit Berührflächen, eine zum Blendenteil beabstandet angeordnete Leiterplatte mit Kontaktstellen und/oder Sensoren, die einer Berührfläche zugeordnet sind und dazu ausgebildet sind, eine elektrische Größe wie Kapazität oder Widerstand zu erfassen und ferner zumindest ein elektrisch leitendes Verbindungselement, das den Abstand zwischen Kontaktstelle oder Sensor zur inneren Fläche des Blendenteils für die entsprechend zugeordnete Berührfläche überbrückt.

Eine derartige Bedienvorrichtung ist aus der DE 10 2007 026 857 A1 bekannt. Hierbei ist im Blendenteil eine Leiterplatte mit den Kontaktflächen bzw. Sensoren angeordnet, die mittels Federn an der Innenseite des Blendenteils elektrisch verbunden sind. Eine Berührung bzw. Annäherung an der jeweils außenseitigen Berührfläche führt zu einer Kapazitätsänderung des Sensors, die entsprechend als Schaltvorgang erfasst und weiterverarbeitet wird. Hierbei bildet das Blendenteil den Aufnahmeraum für die Leiterplatte, so dass es wasserdicht ausgeführt werden muss, da in eine elektronische Schaltung eindringendes Wasser zu Fehlfunktionen oder zur Zerstörung führen kann.

Aus der DE 297 21 212 U1 ist eine ähnliche Bedienvorrichtung bekannt, bei der anstelle von Federn elektrisch leitende Elastomerblöcke zur Überbrückung des Abstandes zwischen Kontaktstelle auf der Leiterplatte und dem Blendenteil verwendet werden. Auch bei dieser Bedienvorrichtung muss das Blendenteil wasserdicht ausgeführt werden.

Der Erfindung liegt somit die Aufgabe zugrunde, eine Bedienvorrichtung bereitzustellen, die bei einfacher und schneller Montage eine gute Dichtigkeit gegen Spritzwasser gewährleistet.

Erfindungsgemäß wird diese Aufgabe durch eine Bedienvorrichtung mit den Merkmalen des Patentanspruchs 1, sowie mit einem Haushaltgerät nach Anspruch 11 und einem Küchengerät nach Anspruch 12 gelöst. Vorteilhafte Ausgestaltungen und Weiterbildungen der Erfindung ergeben sich aus den jeweils nachfolgenden abhängigen Ansprüchen.

Die mit der Erfindung erreichbaren Vorteile bestehen darin, dass die in der Bedienblende enthaltenen Steuerungskomponenten sehr gut gegen Spritzwasser geschützt sind, wobei der Aufbau sehr einfach, kompakt und kostengünstig ist. Das Blendenteil schützt den dahinterliegenden Raum für die Elektronikkomponenten nur teilweise, so dass der Raum nicht wasserdicht ist. Das in diesem Raum angeordnete Elektronikgehäuse schließt dichtend die Leiterplatte mit den Kontaktstellen und elektronischen Bauelementen ein, was einfach in einem frühen Herstellungsschritt geschehen kann. Bei der Endmontage des Gerätes sind keinerlei Maßnahmen zur Bereitstellung der Dichtigkeit erforderlich. Dies wird dadurch erreicht, dass das Gehäuse zur Aufnahme der Leiterplatte zumindest eine Wand zwischen Leiterplatte und Blendenteil umfasst, wobei das Verbindungselement die Wand dichtend durchdringt. In den Aufnahmeraum eindringendes Wasser kann zwar zum Elektronikgehäuse gelangen, es kann jedoch nicht in das Innere des Elektronikgehäuses zur Leiterplatte gelangen.

In einer vorteilhaften Ausführung besteht das Verbindungselement aus einer Schraubfeder, die mit einem Ende auf einer Kontaktstelle der Leiterplatte und mit dem gegenüberliegenden Ende an der Innenseite des Blendenteils im Wirkbereich der jeweils der Kontaktstelle zugeordneten Berührfläche anliegt. Die Schraubfeder besteht aus elektrisch leitendem Metall und liegt unter Druck bzw. mit Kraftbeaufschalgung an den jeweiligen Kontaktflächen an.

In einer anderen, vorteilhaften Ausführung besteht das Verbindungselement aus einer streifenförmigen, C-, S- oder Z-förmig gebogenen Blattfeder, die mit einem Endbereich auf einer Kontaktstelle der Leiterplatte und mit dem gegenüberliegenden Endbereich an der Innenseite des Blendenteils im Wirkbereich der jeweils der Kontaktstelle zugeordneten Berührfläche anliegt. Diese ist recht einfach herzustellen und auf einfache Weise dichtend in der Gehäusewand einsetzbar.

Um den Halt der Feder im Durchdringungsbereich zu verbessern, ist die Wand des Elektronikgehäuses in diesem Bereich verdickt ausgebildet.

Insgesamt ist es zweckmäßig, das Gehäuse im Spritzgussverfahren aus Kunststoff herzustellen und die Feder dichtend mit Kunststoff umspritzt in der Wand einzubetten. Dadurch wird ein dauerhafter und zuverlässiger Halt der Feder in der Gehäusewand bei Beibehaltung der Dichtigkeit erreicht.

In einer anderen Ausführung besteht das Verbindungselement aus einem elektrische leitfähigem Elastomer oder Gummimaterial, das bereichsweise dichtend als Presspassung in eine hierfür vorgesehene Öffnung im Gehäuse eingefügt ist. Das in der Öffnung eingesetzte Elastomerteil wird durch die Presspassung gehalten und bietet gleichzeitig den Verschluss für die Öffnung.

In einer vorteilhaften Weiterbildung ist das Verbindungselement im Bereich außerhalb der Presspassung gitternetzartig ausgebildet. Dadurch ist es im Längsbereich flexibler, so dass sich stark unterscheidende Abstände der Leiterplatte zum Blendenteil überbrücken lassen.

In einer weiteren, vorteilhaften Weiterbildung ist das Verbindungselement im Bereich der Presspassung bzw. der Gehäuseöffnung zylindrisch oder tonnenförmig ausgebildet. Dadurch werden der Halt und die Dichtigkeit nochmals verbessert.

In einer vorteilhaften Ausführung besitzt das Verbindungselement im Bereich der Presspassung einen Vorsprung oder einen umlaufenden Steg zur Verrastung in einen korrespondieren Rezess im Randbereich der Öffnung. Somit wird eine eindeutige, vorgegebene Position in Längsrichtung des Verbindungselements bereitgestellt, da das Elastomerteil in einem Montageschritt in die Gehäuseöffnung eingesteckt werden kann.

Insgesamt ist es zweckmäßig, dass der Sensor dazu ausgebildet ist, eine Kapazitätsänderung oder Widerstandsänderung bei Berührung der Berührfläche zu bewirken. Diese elektrischen Größen können besonders einfach und zuverlässig für einen Schaltzustand ausgewertet werden.

Die Erfindung betrifft auch ein wasserführendes Haushaltgerät wie Waschmaschine, Trockner Waschtrockner oder Geschirrspüler mit einer Bedienvorrichtung wie vorstehend beschrieben. Da das Elektronikgehäuse auf einfache Weise dichtend ausgeführt werden kann, ist es nicht erforderlich, die großen Gehäuseteile oder Blendeteile dichtend auszubilden. Das vereinfacht den Gehäuseaufbau des Haushaltgerätes und bietet auch hinsichtlich des Designs nahezu keine Einschränkungen.

Die Erfindung betrifft ferner ein Küchengerät, wie Herd, Backofen oder Kühlgerät mit einer Bedienvorrichtung wie vorstehend beschrieben. Auch hierbei werden Verschmutzungen oder Fettspritzer aufgrund des zumindest nahezu dichten Elektronikgehäuses einfach von der Leiterplatte ferngehalten.

Bei der Verwendung der Bedienvorrichtung in einem Herd oder Backofen ist es zweckmäßig, das Blendenteil durch einen Bereich einer Glasplatte oder eines Ceranfeldes zu bilden.

Ein Ausführungsbeispiel der Erfindung ist in den Zeichnungen rein schematisch dargestellt und wird nachfolgend näher beschrieben. Es zeigen:
- Fig. 1:: ein Haushaltgerät mit einer Bedienvorrichtung in einer Frontansicht;
- Fig. 2:: die Bedienvorrichtung in einer detaillierten perspektivischen rückseitigen Ansicht;
- Fig. 3:: einen detaillierten Ausschnitt des Bereichs der Anbindung der Schraubfeder und
- Fig. 4:: einen detaillierten Ausschnitt des Bereichs der Anbindung des Elastomerteils.

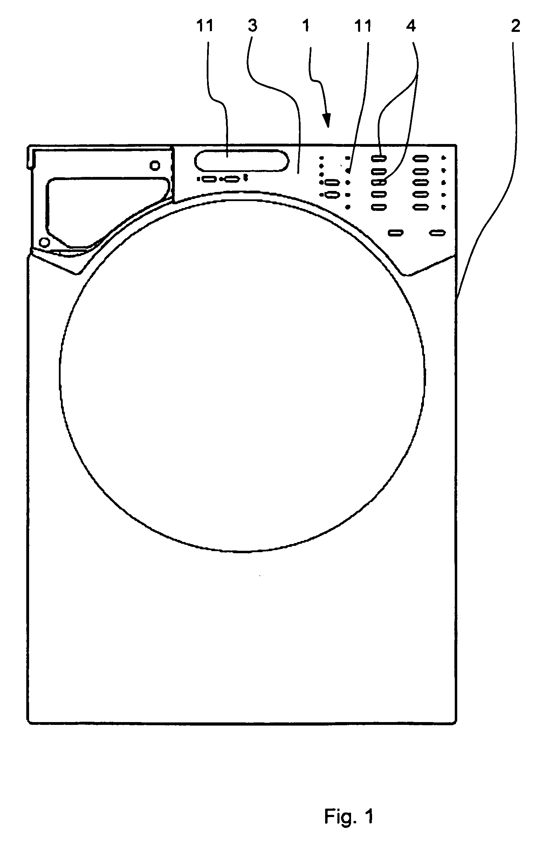

Fig.1 zeigt als wasserführendes Haushaltgerät eine Waschmaschine 2 von der Seite, von der die Bedienung aus erfolgen kann. Im oberen Bereich, bezogen auf die betriebsgemäße Aufstellposition des Gerätes, ist die Bedienvorrichtung 1 angeordnet. Die Bedienvorrichtung 1 umfasst eine für den Benutzer zugängliche Blende 3, die Berührflächen 4 für die Einstellung von Programmen und Parametern aufweist. In der Blende 3 sind ferner Anzeigen 11 in Form von Leuchtanzeigen und/oder Displays angeordnet.

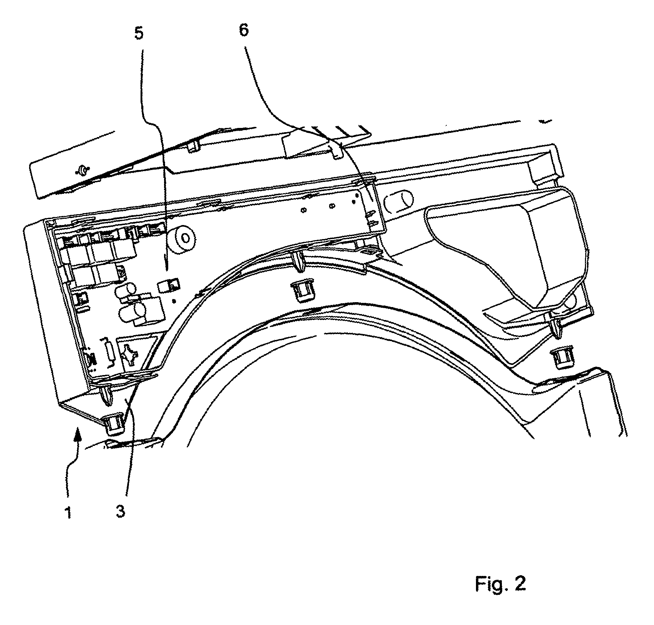

Fig. 2 zeigt die Bedienvorrichtung 1 in einer rückseitigen Ansicht. Hier ist die Innenfläche des Blendenteils 3 zu erkennen, das teilweise mit dem Gehäuse 6 und der darin aufgenommenen Leiterplatte 5 verdeckt ist. Das Gehäuse 6 ist hierbei rückseitig offen, es kann jedoch optional vollständig geschlossen sein, wenn es die Dichtigkeit gegen eindringendes Wasser oder Schmutz erfordert.

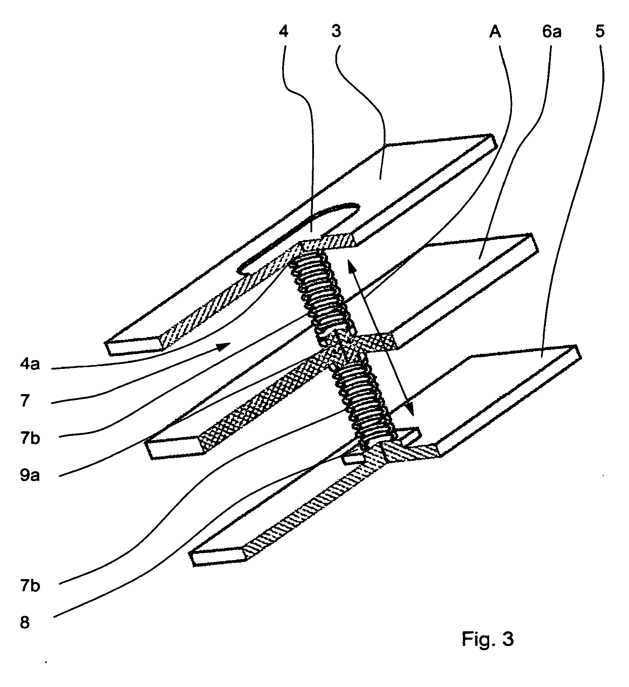

Fig. 3 zeigt schematisch einen Ausschnitt der Bedienvorrichtung 1. Hier ist zu erkennen, dass an der Innenseite 4a des Blendenteils 3 im Bereich der Berührfläche 4 eine Schraubfeder 7a anliegt, die die Wand 6a des Gehäuses 6 durchdringt und innerhalb des Gehäuses 6 zur Kontaktfläche 8 führt. Die Feder steht hierbei unter Federdruck, so dass eine dauerhafte zuverlässige Kontaktierung sichergestellt ist. Die Gehäusewand 6a ist im Durchdringungsbereich 9a etwas dicker ausgebildet, vorzugsweise etwa 1,5 bis 3 mal so dick, wie die Gehäusewand 6a im restlichen Bereich.

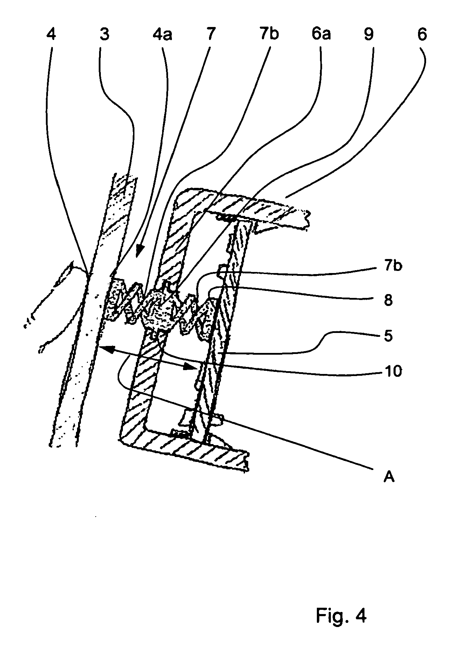

Fig. 4 zeigt eine alternative Ausführung, bei der das Verbindungselement 7 aus einem elektrisch leitfähigen Elastomerteil 7b gebildet ist. Hier ist zu erkennen, dass der Bereich, der die Gehäuseöffnung 9 durchdringt, aus Vollmaterial ausgebildet ist. Der verbleibende Bereich ist gitternetzartig ausgeführt, so dass der Abstand A zwischen der Leiterplatte 5 bzw. der Kontaktstelle 8 und der Innenseite 4a des Blendenteils 3 überbrückt wird. Ferner ist zu erkennen, dass ein Finger auf der Berührfläche 4 aufliegt. Dies führt zu einer Aktivierung des entsprechenden Schaltzustandes, der dieser Berührfläche 4 zugeordnet ist. Der Bereich des Elastomerteils 7b, der sich in der Gehäuseöffnung 9 befindet, ist zylindrisch oder tonnenförmig ausgebildet, so dass kreisförmige Öffnungen zuverlässiger und in der Art eines Stopfens dichtend verschlossen werden können. Das Elastomerteil 7b umfasst ferner einen umlaufenden Steg 10, der in einen Rezess oder in eine umlaufende Nut im Öffnungsrand eingreift, so dass eine Verrastung des Elastomerteils 7b in der Gehäuseöffnung 9 an der vorbestimmten Position bereitgestellt wird.

## Patentansprüche

1. Bedienvorrichtung (1) für ein Haushaltgerät (2), umfassend ein Blendenteil (3) mit Berührflächen (4), eine zum Blendenteil (3) beabstandet angeordnete Leiterplatte (5) mit Kontaktstellen (8) und/oder Sensoren, die einer Berührfläche (4) zugeordnet sind und dazu ausgebildet sind, eine elektrische Größe wie Kapazität oder Widerstand zu erfassen und ferner zumindest ein elektrisch leitendes Verbindungselement (7), das den Abstand zwischen Kontaktstelle (8) oder Sensor zur inneren Fläche des Blendenteils (3) für die entsprechend zugeordnete Berührfläche (4) überbrückt,
**gekennzeichnet durch**
ein Gehäuse (6) zur Aufnahme der Leiterplatte (5), das zumindest eine Wand (6a) zwischen Leiterplatte (5) und Blendenteil (3) umfasst, wobei das Verbindungselement (7) die Wand (6a) dichtend durchdringt.

2. Bedienvorrichtung (1) nach Anspruch 1,
**dadurch gekennzeichnet,**
**dass** das Verbindungselement eine Schraubfeder (7a) ist, die mit einem Ende auf einer Kontaktstelle (8) der Leiterplatte (5) und mit dem gegenüberliegenden Ende an der Innenseite des Blendenteils (3) im Wirkbereich (4a) der jeweils der Kontaktstelle zugeordneten Berührfläche (4) anliegt.

3. Bedienvorrichtung (1) nach Anspruch 1,
**dadurch gekennzeichnet,**
**dass** das Verbindungselement eine streifenförmige, C-, S- oder Z-förmig gebogene Blattfeder ist, die mit einem Endbereich auf einer Kontaktstelle (8) der Leiterplatte (5) und mit dem gegenüberliegenden Endbereich an der Innenseite des Blendenteils (3) im Wirkbereich (4a) der jeweils der Kontaktstelle zugeordneten Berührfläche (4) anliegt.

4. Bedienvorrichtung (1) nach Anspruch 2 oder 3,
**dadurch gekennzeichnet,**
**dass** die Wand (6a) im Durchdringungsbereich (9a) verdickt ausgebildet ist.

5. Bedienvorrichtung (1) nach einem der Ansprüche 2 bis 4,
**dadurch gekennzeichnet,**
**dass** das Gehäuse (6) im Spritzgussverfahren aus Kunststoff hergestellt ist und die Feder (7a) dichtend mit Kunststoff umspritzt in der Wand (6a) eingebettet ist.

6. Bedienvorrichtung (1) nach Anspruch 1,
**dadurch gekennzeichnet,**
**dass** das Verbindungselement (7) aus einem elektrisch leitfähige Elastomer (7b) oder Gummimaterial besteht, das bereichsweise dichtend als Presspassung in eine hierfür vorgesehene Öffnung (9) im Gehäuse (6, 6a) eingefügt ist.

7. Bedienvorrichtung (1) nach Anspruch 6,
**dadurch gekennzeichnet,**
**dass** das elastomere oder gummiartige Verbindungselement (7b) im Bereich außerhalb der Presspassung gitternetzartig ausgebildet ist.

8. Bedienvorrichtung (1) nach Anspruch 6 oder 7,
**dadurch gekennzeichnet,**
**dass** das elastomere oder gummiartige Verbindungselement (7b) im Bereich der Presspassung bzw. der Gehäuseöffnung (9) zylindrisch oder tonnenförmig ausgebildet ist.

9. Bedienvorrichtung (1) nach einem der Ansprüche 6 bis 8,
**dadurch gekennzeichnet,**
**dass** das elastomere oder gummiartige Verbindungselement (7b) im Bereich der Presspassung (9) einen Vorsprung oder einen umlaufenden Steg (10) besitzt, zur Verrastung in einen korrespondieren Rezess im Randbereich der Öffnung (9).

10. Bedienvorrichtung (1) nach Anspruch 1,
**dadurch gekennzeichnet,**
**dass** der Sensor dazu ausgebildet ist, eine Kapazitätsänderung oder Widerstandsänderung bei Berührung der Berührfläche (4) zu bewirken.

11. Wasserführendes Haushaltgerät (2), wie Waschmaschine, Trockner Waschtrockner oder Geschirrspüler mit einer Bedienvorrichtung (1) nach einem der Ansprüche 1 bis 10.

12. Küchengerät, wie Herd, Backofen oder Kühlgerät mit einer Bedienvorrichtung (1) nach einem der Ansprüche 1 bis 10.

13. Küchengerät nach Anspruch 12,
**dadurch gekennzeichnet,**
**dass** das Blendenteil (3) durch einen Bereich einer Glasplatte oder eines Ceranfeldes gebildet ist.

## Claims

1. Operating device (1) for a domestic appliance (2), comprising a panel part (3) having contact surfaces (4), a printed circuit board (5) arranged at a distance from the panel part (3) and having contact points (8) and/or sensors, which are assigned to a contact surface (4) and are configured to detect an electrical variable such as capacitance or resistance, and also at least one electrically conductive connection element (7) which bridges the gap between the contact point (8) or sensor and the internal surface of the panel part (3) for the correspondingly assigned contact surface (4),
**characterised by**
a housing (6) for receiving the printed circuit board (5), which housing comprises at least a wall (6a) between the printed circuit board (5) and panel part (3), the connection element (7) penetrating the wall (6a) in a sealing manner.

2. Operating device (1) according to claim 1,
**characterised in that**
the connection element is a helical spring (7a), one end of which rests on a contact point (8) of the printed circuit board (5) and the opposite end of which rests against the inside of the panel part (3) in the operative region (4a) of the contact surface (4) respectively assigned to the contact point.

3. Operating device (1) according to claim 1,
**characterised in that**
the connection element is a strip-shaped, C-, S-, or Z-shaped curved leaf spring, one end region of which rests having on a contact point (8) of the printed circuit board (5) and the opposite end region of which rests against the inside of the panel part (3) in the operative region (4a) of the contact surface (4) respectively assigned to the contact point.

4. Operating device (1) according to claim 2 or claim 3,
**characterised in that**
the wall (6a) is thickened in the penetration region (9a).

5. Operating device (1) according to any one of claims 2 to 4,
**characterised in that**
the housing (6) is produced from plastics material by the injection moulding process, and the spring (7a), is encapsulated in plastics material in a sealing manner and is embedded in the wall (6a).

6. Operating device (1) according to claim 1,
**characterised in that**
the connection element (7) consists of an electrically conductive elastomer (7b) or rubber material, which is inserted in regions in a sealing manner with an interference fit into an opening (9) provided for this purpose in the housing (6, 6a).

7. Operating device (1) according to claim 6,
**characterised in that**
the elastomeric or rubber-like connection element (7b) is configured in a grid-like manner in the region outside the interference fit.

8. Operating device (1) according to claim 6 or claim 7,
**characterised in that**
the elastomeric or rubber-like connection element (7b) is cylindrical or barrel-shaped in the region of the interference fit and the housing opening (9).

9. Operating device (1) according to any one of claims 6 to 8,
**characterised in that**
the elastomeric or rubber-like connection element (7b) has, in the region of the interference fit (9), a projection or a peripheral web (10) for locking into a corresponding recess in the edge region of the opening (9).

10. Operating device (1) according to claim 1,
**characterised in that**
the sensor is configured to effect a change in capacitance or resistance when the contact surface (4) is contacted.

11. Water-conducting domestic appliance (2), such as a washing machine, dryer, washer-dryer, or dishwasher, having a operating device (1) according to any one of claims 1 to 10.

12. Kitchen appliance, such as a cooker, oven or refrigerator, having a operating device (1) according to any one of claims 1 to 10.

13. Kitchen appliance according to claim 12,
**characterised in that**
the panel part (3) is formed by a region of a glass plate or a ceramic glass cooktop.

## Revendications

1. Dispositif de manoeuvre (1) pour un appareil ménager (2), comprenant un bandeau (3) avec des surfaces de contact (4), une carte de circuit (5) disposée à distance du bandeau (3), avec des emplacements de contact (8) et/ou des capteurs qui sont affectés à une surface de contact (4) et qui sont constitués pour détecter une grandeur électrique comme la capacité ou la résistance, et en outre au moins un élément de connexion (7) électriquement conducteur qui enjambe l'espace entre l'emplacement de contact (8) ou le capteur et la surface intérieure du bandeau (3) pour la surface de contact (4) affectée en conséquence,
**caractérisé par**
un boîtier (6) pour loger la carte de circuit (5), qui comprend au moins une paroi (6a) entre la carte de circuit (5) et le bandeau (3), l'élément de connexion (7) pénétrant de façon étanche dans la paroi (6a).

2. Dispositif de manoeuvre (1 ) selon la revendication 1,
**caractérisé en ce que**
l'élément de connexion est un ressort hélicoïdal (7a) qui, par une extrémité, appuie sur un emplacement de contact (8) de la carte de circuit (5) et, par l'extrémité opposée, appuie sur le côté intérieur du bandeau (3) dans la zone d'action (4a) de la surface de contact (4) respectivement affectée à l'emplacement de contact.

3. Dispositif de manoeuvre (1 ) selon la revendication 1,
**caractérisé en ce que**
l'élément de connexion est un ressort à lame en forme de bande, cintré en forme de C, de S ou de Z qui, par une zone d'extrémité, appuie sur un emplacement de contact (8) de la carte de circuit (5) et, par la zone d'extrémité opposée, appuie sur le côté intérieur du bandeau (3) dans la zone d'action (4a) de la surface de contact (4) respectivement affectée à l'emplacement de contact.

4. Dispositif de manoeuvre (1 ) selon la revendication 2 ou la revendication 3,
**caractérisé en ce que**
la paroi (6a) est constituée de façon épaissie dans la zone de pénétration (9a).

5. Dispositif de manoeuvre (1) selon l'une quelconque des revendications 2 à 4,
**caractérisé en ce que**
le boîtier (6) est réalisé en matière plastique selon le procédé de moulage par injection, et le ressort (7a) est noyé dans la paroi (6a) de façon étanche, enrobé de matière plastique.

6. Dispositif de manoeuvre (1 ) selon la revendication 1,
**caractérisé en ce que**
l'élément de connexion (7) se compose d'un élastomère (7b) ou matériau en caoutchouc électriquement conducteur qui est, par segments, inséré de façon étanche en tant qu'ajustement serré dans une ouverture (9) dans le boîtier (6, 6a) prévue à cet effet.

7. Dispositif de manoeuvre (1) selon la revendication 6,
**caractérisé en ce que**
l'élément de connexion (7b) en élastomère ou du type caoutchouc est, dans la zone à l'extérieur de l'ajustement serré, constitué à la façon d'un quadrillage.

8. Dispositif de manoeuvre (1) selon la revendication 6 ou la revendication 7,
**caractérisé en ce que**
l'élément de connexion (7b) en élastomère ou du type caoutchouc est, dans la zone de l'ajustement serré et de l'ouverture de boîtier (9), constitué de façon cylindrique ou à la façon d'un tonneau.

9. Dispositif de manoeuvre (1) selon l'une quelconque des revendications 6 à 8,
**caractérisé en ce que**
l'élément de connexion (7b) en élastomère ou du type caoutchouc possède, dans la zone de l'ajustement serré (9), une saillie ou une bande (10) périphérique, pour l'encliquetage dans un creux correspondant dans la zone marginale de l'ouverture (9).

10. Dispositif de manoeuvre (1) selon la revendication 1,
**caractérisé en ce que**
le capteur est constitué pour provoquer une variation de capacité ou une variation de résistance lorsque l'on touche la surface de contact (4).

11. Appareil ménager (2) transportant de l'eau, tel que lave-linge, sécheur, laveur-sécheur ou lave-vaisselle, avec un dispositif de manoeuvre (1) selon l'une quelconque des revendications 1 à 10.

12. Appareil de cuisine, tel que cuisinière, four ou réfrigérateur, avec un dispositif de manoeuvre (1) selon l'une quelconque des revendications 1 à 10.

13. Appareil de cuisine selon la revendication 12,
**caractérisé en ce que**
le bandeau (3) est formé par une zone d'une plaque de verre ou d'une plaque vitrocéramique.
